Europäisches Patentamt

European Patent Office

Office européen des brevets

(11) Publication number: **0 425 837 B1**

# EUROPEAN PATENT SPECIFICATION

(45) Date of publication of patent specification: **17.08.94** (51) Int. Cl.5: **C30B 15/00**, C30B 29/06

(21) Application number: **90119091.8**

(22) Date of filing: **05.10.90**

(54) **Method of adjusting concentration of oxygen in silicon single crystal and apparatus for use in the method.**

(30) Priority: **05.10.89 JP 260710/89**

(43) Date of publication of application:
**08.05.91 Bulletin 91/19**

(45) Publication of the grant of the patent:
**17.08.94 Bulletin 94/33**

(84) Designated Contracting States:
**DE FR GB**

(56) References cited:
**DE-A- 3 905 626**
**FR-A- 2 329 343**

(73) Proprietor: **SHIN-ETSU HANDOTAI COMPANY LIMITED**
**4-2, Marunouchi 1-Chome**
**Chiyoda-ku Tokyo (JP)**

(72) Inventor: **Sonokawa, Susumu**
**4-1-13, Kitago,**
**Takehu-shi**
**Hukui 915 (JP)**
Inventor: **Araki, Kenji**
**4-1-13, Kitago,**
**Takehu-shi**
**Hukui 915 (JP)**

Inventor: **Iwasaki, Atsushi**
**3-2-8, Kitago,**
**Takehu-shi**
**Hukui 915 (JP)**
Inventor: **Baba, Masahiko A-5-3, Kohu apartment bldg. 791-4**
**Yanase,**
**Annaka-shi**
**Gunma 379-01 (JP)**

(74) Representative: **Rau, Manfred, Dr. Dipl.-Ing. et al**
**Rau, Schneck & Hübner**
**Patentanwälte**
**Königstrasse 2**
**D-90402 Nürnberg (DE)**

# Description

## Field of the Invention

The present invention relates to a method which adjusts the concentration of oxygen in a silicon (Si) single crystal and which is used in a single crystal pulling apparatus using the Czochralski method and to a apparatus for use in the adjusting method.

## Description of Prior Art

When a Si single crystal is pulled up from Si molten liquid in a quartz crucible using the CZ method, volatile silicon oxide (SiO) is produced by the reaction between the quartz crucible and the Si molten liquid and deposits on an edge of the crucible, the Si single crystal, a pulling shaft and an inside wall of a chamber. The SiO which deposits on the pulling shaft which is ascending while rotating is scraped by an airtight seal ring and falls into the molten liquid below, so that the single crystal being produced is damaged. In order to solve this problem, a method is suggested (in Japanese Examined Patent No.54-6511) in which a purge tube is hung down to be concentric with the pulling shaft in the chamber, argon (Ar) gas is allowed to flow down in a straightening tube from above, and the SiO which evaporates from the surface of the molten liquid together with the Ar gas is exhausted through the bottom of the chamber.

On the other hand, the SiO is also absorbed into the Si single crystal. Since oxygen in the Si single crystal functions as the main element of gettering effect against impurities intruding in the process of producing an integrated circuit, it has been conventionally thought that a preferable concentration of oxygen in the Si single crystal should be approximately 20ppma (by ASTM F121-83). However, the integration of a semiconductor device has recently reached a high level, and it has been revealed that oxygen in the Si single crystal causes an oxygen inducing fault (OISF) and a swirl fault. As a result, manufacturers of semiconductor devices need a Si single crystal in which the concentration of oxygen is lower than 15ppma.

The following methods are provided in order to lower the concentration of oxygen in the Si single crystal:

(A) to reduce the reaction between the Si molten liquid and the quartz crucible by decreasing the number of rotations of the quartz crucible

(B) to increase the amount of volatilized SiO by increasing the flow rate of inert gas flowing through the straightening tube

(C) to increase the amount of volatilized SiO by lowering the pressure in the chamber

However, in the case of the method (A), if the number of rotations is too small, the temperature distribution in the Si molten liquid is prevented from being even. In the method (B), since the flow rate of the inert gas is required to be considerably high (normally, 50-100ℓ/min increased), its costs are increased. In the case of the method (C), if the pressure is too low, the reaction between the quartz crucible and the Si molten liquid becomes large, the life of the quartz crucible is shortened, and the production costs are increased.

## SUMMARY OF THE INVENTION

An object of the present invention is to provide an oxygen concentration adjusting method capable of lowering the concentration of oxygen in a Si single crystal and making the concentration even in the overall length of the Si single crystal without causing the above problems and an apparatus for use in the method.

In order to achieve this object, a method according to claims 1-6 is provided.

If only the flow rate of the inert gas flowing down through the straightening tube is changed, its costs are high, and furthermore, it is difficult for the gas flowing out of the straightening tube to reach the surface of the Si molten liquid because of ascending flow produced by heat or radiation from the surface of the Si molten liquid, and the effect of removing SiO by way of volatilizing from the Si molten liquid is reduced and made unstable.

However, according to the present invention, it is possible to adjust the amount of oxygen brought into the Si single crystal to a low value by stably and smoothly changing the flow speed of the inert gas passing between the bottom end of the straightening tube and the surface of the Si molten liquid, and thereby changing the amount of the SiO volatilized from the Si molten liquid, without changing the flow rate of the inert gas flowing down through the straightening tube. Therefore, it is possible to adjust the concentration of oxygen in the Si single crystal without causing any of the above problems.

The above distance between the surface of the Si molten liquid and the bottom end of the straightening tube can be changed by elevating one or both of the straightening tube and the quartz crucible.

The above method is carried out by the apparatuses according to claims 7-11.

BRIEF DESCRIPTION OF THE DRAWINGS

Figs.1 to 4 are views of a first embodiment of a method of adjusting the concentration of oxygen in a Si single crystal and an apparatus for use in the method according to the present invention:

Fig.1 is a view showing the main mechanical composition of a single crystal pulling apparatus;

Fig.2 is a diagram of a surface level control circuit;

Fig.3 is a flowchart showing the composition of software of a microcomputer 52 shown in Fig.2; and

Fig.4 is a diagram showing the relationship between the distance Y between the surface and an upper end of a crystal body and the distance H between the surface and the bottom end of a straightening tube,

Fig.5 is a graph of the concentration profile of oxygen in a crystal with respect to the position Y in the axial direction downward from the upper end of the crystal body according to results of experiments using the apparatus of the first embodiment and a conventional apparatus,

Figs.6 to 8 are views of a second embodiment of the present invention:

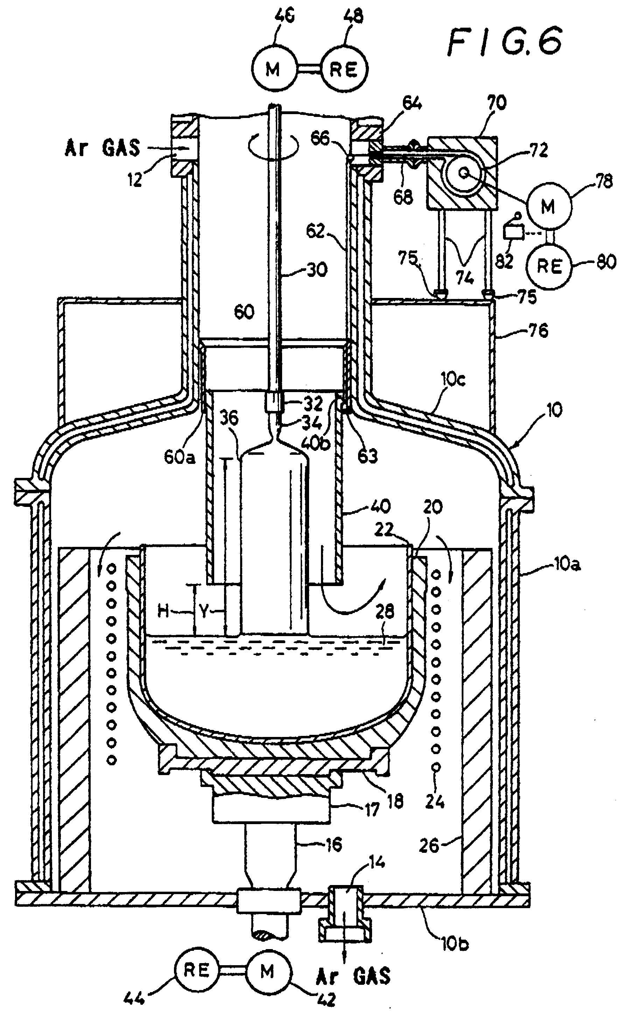

Fig.6 is a view showing the main mechanical composition of a single crystal pulling apparatus;

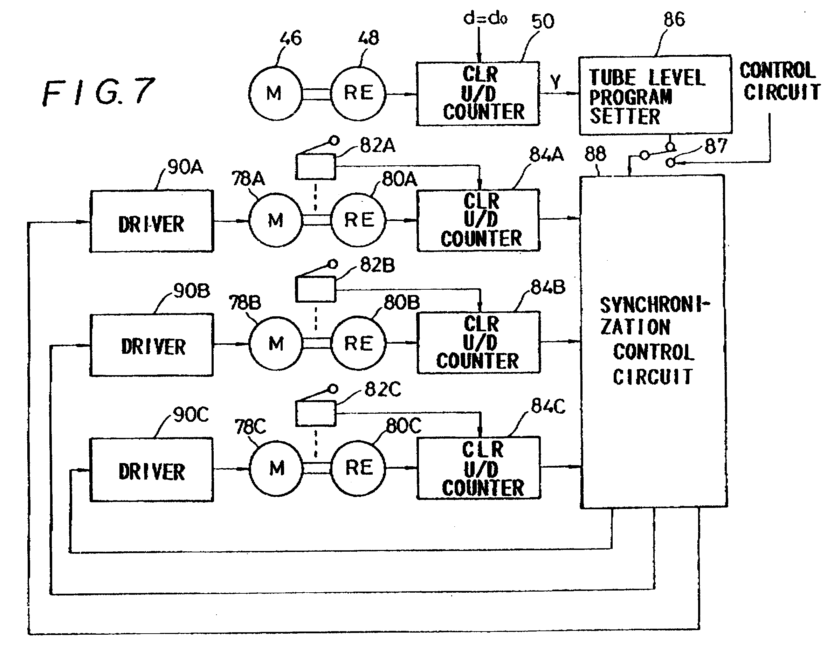

Fig.7 is a diagram of a straightening tube height control circuit; and

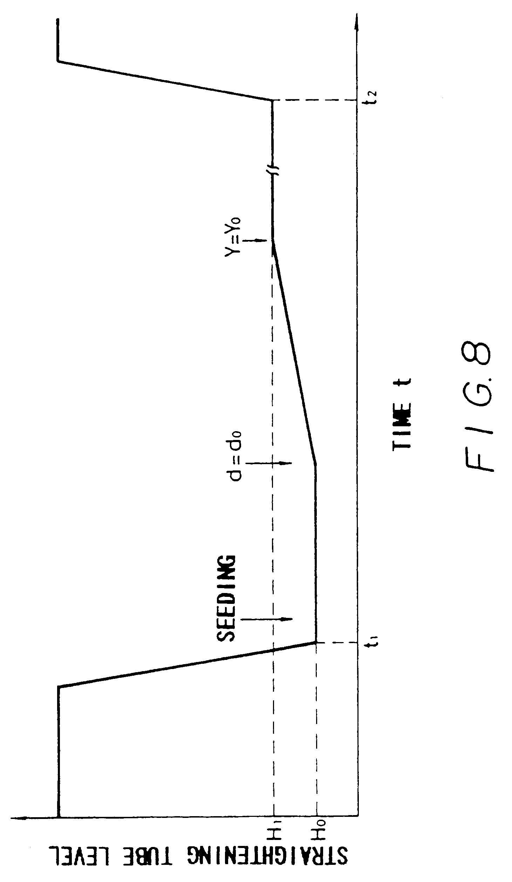

Fig.8 is a diagram showing the relationship between the time t and the height H of a straightening tube.

DESCRIPTION OF THE PREFERRED EMBODIMENTS

The first embodiment of the present invention will now be described with reference to the drawings.

(1) First Embodiment

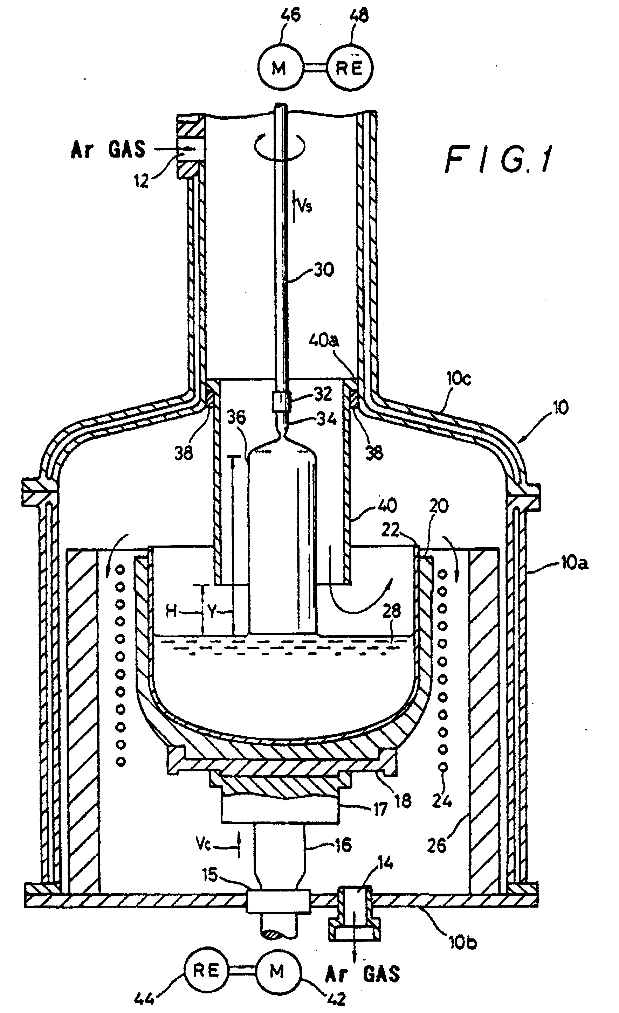

Fig.1 shows the main mechanical composition of a single crystal pulling apparatus.

A bottom opening of a cylindrical body 10a of a chamber 10 is covered with a floor plate 10b, and a lid 10c composed of a shoulder portion and a cylindrical portion having a small diameter is connected to a top opening of the body 10a. An inlet 12 for introducing Ar gas is formed on a side wall of the cylindrical portion of the lid 10c, and an outlet 14 for exhausting the Ar gas is formed on the floor plate 10b. A seal ring 15 is mounted at the center of the floor plate 10b and a rotary elevator shaft 16 pierces through the seal ring 15. A pedestal 17 is fixed at the top end of the rotary elevator shaft 16 and a graphite crucible 20 is laid on the pedestal 17 through a table 18. A quartz crucible 22 is fitted into the graphite crucible 20. The periphery of the graphite crucible 20 is surrounded by a heater 24 and the periphery off the heater 24 is surrounded by a graphite heat-insulating material 26. Therefore, when polycrystals of Si are put into the quartz crucible 22 and electric power is supplied to the heater 24, the Si polycrystals are melted into Si molten liquid 28.

On the other hand, a seed crystal 34 is retained through a seed holder 32 at the bottom of a pulling shaft 30 which is moved up and dawn along the center line of the chamber 10. By dipping the seed crystal 34 in the Si molten liquid 28 and pulling the seed crystal 34 up, a Si single crystal rod 36 is formed. A plurality of arc stoppers 38 are fixed on the inside wall at the bottom of the cylindrical portion of the lid 10c, and an outward flange 40a formed at the top end of a straightening tube 40 is caught by the arc stoppers 38. In this caught state, the center line off the straightening tube 40 coincides with that of the chamber 10.

The rotary elevator shaft 16 is moved up and down by a motor 42 and the rotary shaft of a rotary encoder 44 is connected to the rotary shaft of the motor 42. Similarly, the pulling shaft 30 is moved up and down by a motor 46 and the rotary shaft of a rotary encoder 48 is connected to the rotary shaft of the motor 46.

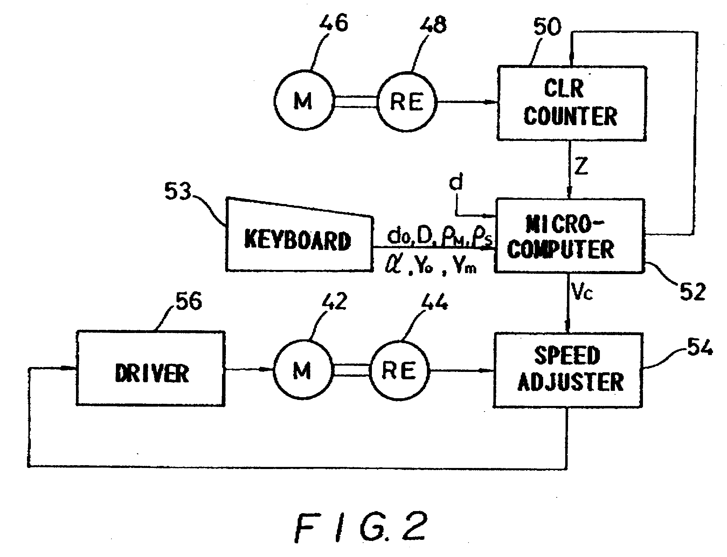

As shown in Fig.2, output pulses from the rotary encoder 48 are supplied to a counter 50 to be counted and the count value Z of the counter 50 is supplied to a microcomputer 52. Supplied to the microcomputer 52 by operations of a keyboard 53 are a reference diameter do of the body of the Si crystal rod 36, the inner diameter D of the quartz crucible 22, the concentration $\rho_M$ of the Si molten liquid, the concentration $\rho_s$ of the Si single crystal, a reference length Ym of the body and $Y_o$ described below. The diameter d of the growing end of the Si single crystal rod 36 is also supplied to the microcomputer 52. The diameter d is measured by taking a picture of the growing end of the Si single crystal rod 36 by an unillustrated ITV and processing image signals thereof. The microcomputer 52 calculates a reference value $V_c$ of the elevation speed of the rotary elevator shaft 16 by using the above Z, d, $d_o$, D, $\rho_M$, $\rho_s$, $Y_o$ and $Y_m$ and supplies the reference value Vc to a speed adjuster 54. The speed adjuster 54 rotatably drives the motor 42 through a driver 56, measures the elevation speed of the rotary elevator shaft 16 in accordance with output pulses from the rotary encoder 44, and exercises control so that the measured speed equal the reference speed $V_c$.

The operations of the embodiment having the above composition will be described.

The pressure in the chamber 10 is decreased by a vacuum pump, Ar gas is supplied to the chamber 10 from the inlet 12, and simultaneously, the Ar gas is sucked and exhausted from the outlet 14. The pressure in the chamber 10 is properly set in accordance with the purpose by adjusting the supply amount or the exhaust amount of the Ar gas. Then, electric power is supplied to the heater 24 so as to heat and melt polycrystal silicon in the quartz crucible 22 and form molten liquid 28. Subsequently, the seed crystal 34 is dipped in the molten liquid 28 by lowering the pulling shaft 30 and the single crystal 36 is produced by pulling the pulling shaft 30 up.

At this time, the Ar gas flows down in the straightening tube 40, passes between the bottom end of the straightening tube 40 and the liquid surface 28a and between the outer peripheral surface of the straightening tube 40 and the inside of the quartz crucible 22, is exhausted out of the quartz crucible 22, descends, and is sucked and exhausted from the outlet 14.

Therefore, the volatile SiO produced by the reaction between the molten liquid 28 and the quartz crucible 22 is exhausted from the outlet 14 together with the flow of the Ar gas, so that it is possible to prevent the SiO from depositing on the inner periphery of the quartz crucible 22, the single crystal 36, the seed holder 32, the polling shaft 30 and so on.

Since the amount of the SiO volatilized from the liquid surface 28 is increased by the flow of the Ar gas and the concentration of oxygen in the single crystal 36 is lowered, the oxygen related faults and swirl faults are reduced. The amount of the volatilized SiO depends upon the flow speed of the Ar gas passing through between the liquid surface 28a and the bottom end of the straightening tube 40.

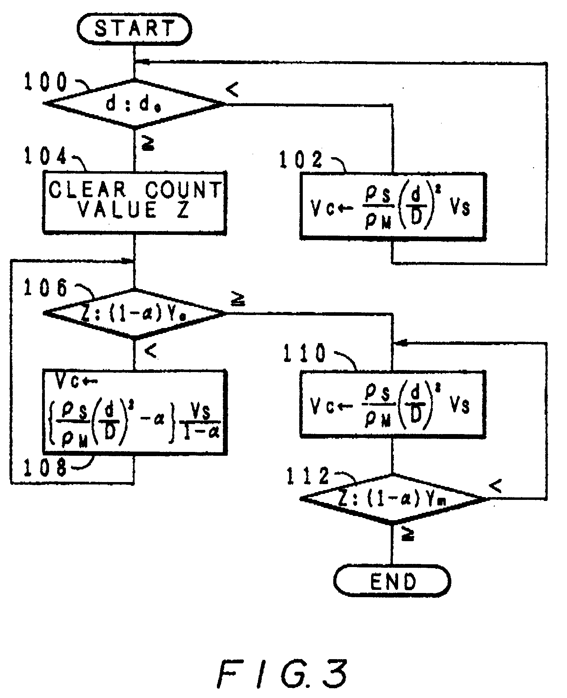

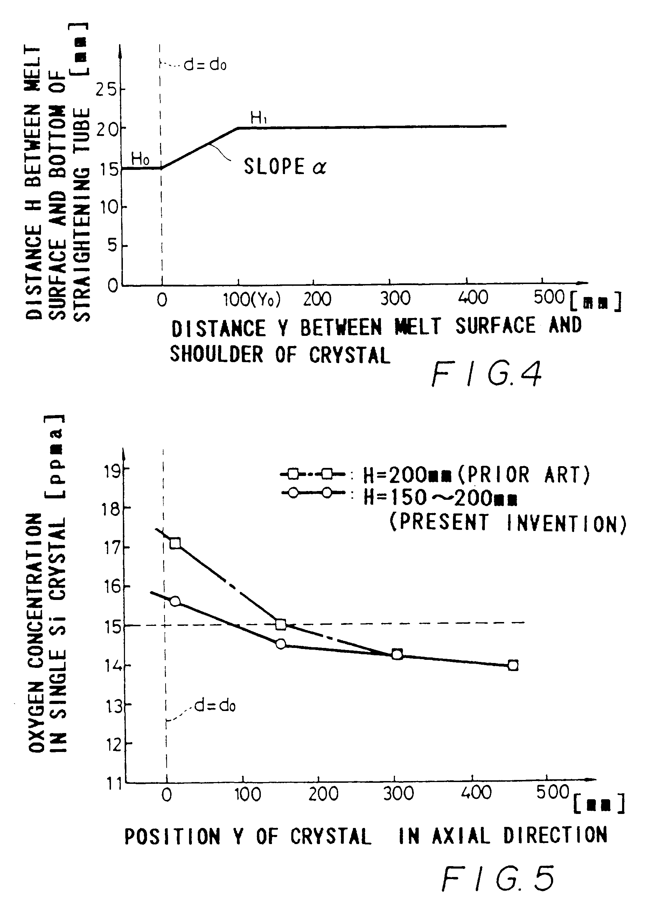

Fig.4 shows an example of the control of the distance H between the liquid surface 28a and the bottom end of the straightening tube 40 (the liquid surface level H) with respect to the distance Y between the liquid surface 28a and the upper end of the body of the single crystal 36. In this example, the distance H is set at a fixed value $H_o$ since the seeding is performed until the upper end of the body of the Si single crystal rod 36 is detected, and then increased by the ratio $\Delta H/\Delta Y$ ($\Delta$ represents the increment) $= \alpha$ until $Y = Y_o$, and H is set at a fixed value $H_1$ when $Y > Y_o$. If the pulling speed of the crystal is constant, the equation $\alpha = (H_1-H_0)/Y_0$ is valid, and if the pulling speed is not constant, the equation is approximately valid, Fig.3 shows the software of the microcomputer 52 for making the supply and exhaust amount of the Ar gas for the chamber 10 constant and controlling the liquid surface level H as shown in Fig.4.

(Step 100) If $d < d_0$,

(Step 102) $Vc = (\rho s/\rho M) \cdot (d/D)^2$ is calculated. The $V_c$ is supplied to the speed adjuster 54 and the level of the liquid surface 28a is set at the fixed value $H_0$. $V_s$ represents the elevation speed of the crystal pulling shaft 30 and is proportional to the time differential value of the count value Z of the counter 50. The proportional constant is 1 hereinafter. The equation $Z = (1-\alpha)Y$ is normally valid. $V_s$ is sometimes used to control the diameter d of the crystal, and in this case, it is substantially constant.

If it is judged in Step 100 that $d \geq d_0$, that is, if the leading end of the body of the Si single crystal rod 36 is detected,

(Step 104) A clear pulse is supplied to the counter 50 so as to clear the count value Z.

(Step 106) If $Z < (1-\alpha)Y_0$,

(Step 108) $V_c = \{(\rho_S/\rho_M)(d/D)^2-\alpha\}V_s/(1-\alpha)$ is calculated and supplied to the speed adjuster 54 so as to lower the level of the liquid surface 28a at the speed of $\alpha V_s/(1-\alpha)$.

If it is judged in Step 106 that $Z \geq (1-\alpha)Y_0$,

(Step 110) $V_c = (\rho_S/\rho_M)(d/D)^2V_s$ is calculated in the same manner as in Step 102, and supplied to the speed adjuster 54 so as to make H at a fixed value $H_2$.

(Step 112) If $Z < (1-\alpha)Y_m$, Step 110 is repeated. If $Z \geq (1-\alpha)Y_m$, the process ends.

(2) Experiment Example

Fig.5 shows the concentration (ppma) of oxygen in the crystal with respect to the position of the leading end of the body of the Si single crystal 36 in the axial direction. Referring to Fig.5, □ represents the measured value where the level H of the liquid surface is fixed at 200mm, and ○ represents the measured value where the level H of the liquid surface is changed as shown in Fig.4. $H_0$ is 15mm, $H_1$ is 20mm, and $Y_0$ is 100mm. In both cases, other conditions are as follows:

Pressure in chamber 10: 30mbar

Flow rate of Ar gas : 50ℓ/min

Rotation speed of quartz crucible 22: 6rpm where Y = 0~100mm {6 + (Y-100)/150} rpm where Y > 100mm

As shown in Fig.5, for example, if the specification of the concentration of oxygen which the semiconductor device manufacturer requests is 13~15ppma and the level of the liquid surface is fixed, the portion of the Si single crystal rod 36 of Y = 0~15cm does not meet the requested specification and results in an inferior product. However, the length of the inferior portion can be reduced by almost half by controlling the level of the liquid surface.

**(3) Second Embodiment**

Fig.6 shows the main mechanical composition of a single crystal pulling apparatus of a second embodiment.

In this apparatus, an outward flange 40b is formed on the top of the straightening tube 40 and an inward flange 60a is formed at the bottom of a tube holder 60. The outward flange 40b is retained on the inward flange 60a by inserting the straightening tube 40 into the tube holder 60. A piercing hole is formed in parallel with the center line of the tube holder 60 on the side wall of the tube holder 60 and a tungsten wire 62 passes through the hole. A fastening pin 63 is fixed at the bottom end of the tungsten wire 62. The tungsten wire 62 is caught around a guide pulley 66 supported by a joint 64 and drawn outside the joint 64. A housing 70 is connected to the outer end of the joint 64 through a connecting tube 68. A take-up drum 72 is pivotally supported in the housing 70. The tungsten wire 62 passes through the connecting tube 68 and the housing 70 and is wound around the take-up drum 72 The top ends of legs 74 are fixed to the bottom plane of the housing 70, and rubber vibration insulators 75 are mounted under the bottom ends of the legs 74 and on a support stand 76 fixed on the lid 10c.

The take-up drum 72 is rotatably driven by a motor 78. The rotary shaft of a rotary encoder 80 is connected to the rotary shaft of the motor 78, and a cam-type limit switch 82 for detecting the reference position is mounted to the rotary shaft of the motor 78.

Three pairs of constituents having the same composition as that of the constituents 62 to 75, 78 and 80 are disposed 120° apart around the center line of the lid 10c, and represented by the above numerals with A to C to make a distinction between the three pairs.

As shown in Fig.7, the output pulses from the rotary encoders 80A to 80C are supplied to up/down counters 84A to 84C respectively and counted. The count values of the up/down counters 84A to 84C are zero-cleared by reference position detection signals from she limit switches 82A to 82C respectively. On the other hand, the output pulses from the rotary encoder 48 are supplied to the counter 50 so as to be counted in the same manner as shown in Fig.2. The counter 50 is zero-cleared in response to the detection of $d = d_0$, that is, the detection of the leading end of the body. The count value Y of the counter 50 is supplied to a program setting unit 86, which supplies the height setting value designated by the count value Y to a synchronization control circuit 88 through a selector switch 87. The synchronization control circuit 88 rotatably drives the motors 78A to 78C through drivers 90A to 90C so that each of the count values is equal to the set value.

Fig.8 shows the relationship between the time t and the height H of the straightening tube 40 The selector switch 87 is set on the side of the program setting unit 86 during the time $t_1$ to $t_2$. Before $t_1$ and after $t_2$, the selector switch 87 is set on the side of an unillustrated control circuit. If $t < t_1$, the straightening tube 40 is lowered from its initial position (the reference position) to $H_0$ at constant speed, and if $t < t_2$, it is raised from $H_1$ to the initial position at constant speed.

Although the case in which H linearly increases while $Y = 0 \sim Y_0$ is described in the above embodiment, H may curvilinearly increase in relation to the pattern of the rotation speed of the quartz crucible 22 and so on. The curved pattern is determined based on the experiment data in the same manner as the linear pattern.

Needless to say, both the level of the liquid surface and the height of the straightening tube 40 may be controlled in accordance with the purpose.

**Claims**

1. A method of producing a Si single crystal (36) by disposing a straightening tube (40) concentrically with and above a quartz crucible (22), letting inert gas flow down through said straightening tube, dipping a seed crystal in Si molten liquid (28) in said quartz crucible, and then pulling said seed crystal up, the method further comprises adjusting the concentration of oxygen in said Si single crystal by controlling the distance (H) between the surface of said Si molten liquid and the bottom end of said straightening tube in accordance with a variable (Y) which is either a pull-up length or a pull-up time from a certain growth point of said Si single crystal such that the distance H during the crystal growth increases or is kept constant at a wanted value $H_0$ or $H_1$.

2. A method according to claim 1, wherein the distance (H) between the surface of said Si molten liquid (28) and the bottom end of said straightening tube (40) is controlled by fixing said straightening tube and elevating said quartz crucible (22) such that the distance H during the crystal growth increases or is kept constant at a wanted value $H_0$ or $H_1$.

3. A method according to claim 1, wherein the distance (H) between the surface of said Si molten liquid (28) and the bottom end of said straightening tube (40) is controlled by fixing the level of said quartz crucible (22) and elevating said straightening tube.

4. A method according to claim 1, wherein the distance (H) between the surface of said Si molten liquid (28) and the bottom end of said straightening tube (40) is controlled by elevating both said straightening tube and said quartz crucible (22) such that the distance H during the crystal growth increases or is kept konstant at a wanted value $H_0$ or $H_1$.

5. A method according to claim 4, wherein said quartz crucible (22) is raised in order to maintain a level of the surface of said Si molten liquid (28) such that the distance H during the crystal growth increases or is kept konstant at a wanted value $H_0$ or $H_1$.

6. A method according to claim 1, wherein the level of the bottom end of said straightening tube (40) is constant until the upper end of a cylindrical portion of said Si single crystal (36) is detected, the distance (H) between the surface of said Si molten liquid (28) and the bottom end of said straightening tube is increased in accordance with the increase of said variable (Y) during a pull-up length or a pull-up time from said leading end, and the level of said straightening tube is constant until the whole of said Si single crystal (36) is produced after said length has been pulled or said time has passed.

7. An apparatus for adjusting the concentration of oxygen in a Si single crystal, including a quartz crucible (22) which contains Si molten liquid (28) therein and a straightening tube (40) which is disposed concentrically with and above said quartz crucible (22) and through which inert gas flows down, and producing a Si single crystal (36) by dipping a seed crystal in said Si molten liquid and then pulling said seed crystal up, comprising:

means for measuring a variable Z which is either a pull-up length or a pull-up time from a certain growth point of said Si single crystal;

a motor (42) for elevating said quartz crucible;

means (53) for setting a cylindrical portion diameter $d_0$ of said Si single crystal, a inner diameter D of said crucible (22), a density $\rho_s$ of said Si single crystal, a density $\rho_m$ of said Si molten liquid, a certain length $Y_0$ of said Si single crystal and a constant $\alpha$;

means for calculating a reference value $V_c$ of the elevation speed of said quartz crucible as follows:

if $d < d_0$, then $V_c = (\rho_s/\rho_m)(d/D)^2 V_s$, where $V_s$ is pulling up speed of said Si single crystal,

if $d \geq d_0$, then if $Z < (1-\alpha)Y_0$ then $V_c = \{-(\rho_s/\rho_m)(d/D)^2-\alpha\} V_s/(1-\alpha)$, else $V_c = (\rho_s/\rho_m)(d/D)^{-2}V_s$

means for controlling the rotation speed of said motor so that the elevation speed of said quartz crucible is equal to said reference value $V_c$.

8. An apparatus for adjusting the concentration of oxygen in a Si single crystal, including a quartz crucible (22) which contains Si molten liquid (28) therein and a straightening tube (40) which is disposed concentrically with and above said quartz crucible (22) and through which inert gas flows down, and producing a Si single crystal (36) by dipping a seed crystal in said Si molten liquid and then pulling said seed crystal up, comprising:

means for measuring a variable Z which is either a pull-up length or a pull-up time from a certain growth point of said Si single crystal;

motors (78A to 78C) for elevating said straightening tube;

means (80A to 80C) for measuring the level of said straightening tube;

means (86) for setting a reference level of said straightening tube so as to make the distance between the surface of said Si molten liquid and the bottom end of said straightening tube increase during the crystal growth or keep it at a constant value; and

means (88) for controlling the rotational speed of said motors so that the level of said straightening tube is equal to said reference level.

9. An apparatus according to claim 8', wherein starting from the leading end of a cylindrical portion of said Si single crystal (36), said reference level increases proportionally in accordance with the increase of said variable Z.

10. An apparatus for adjusting the concentration of oxygen in a Si single crystal, including a quartz crucible (22) which contains Si molten liquid (28) therein and a straightening tube (40) which is disposed concentrically with and above said quartz crucible (22) and through which inert gas flows down, and producing a Si single crystal (36) by dipping a seed crystal in said Si molten liquid and then pulling said seed crystal up, comprising:

a motor (42) for elevating said quartz crucible;

means for calculating a reference value of the elevation speed of said quartz crucible so as to make the level of the surface of said Si molten liquid constant;

means (54) for controlling the rotational speed of the motor so that said elevation speed of said quartz crucible is equal to said reference value;

means (48 and 50) for measuring a variable $Z$ which is either a pull-up length or a pull-up time from a certain growth point of said Si single crystal;

motors (78A to 78C) for elevating said straightening tube;

means (80A to 80C) for measuring the level of said straightening tube;

means (86) for setting a reference level if said straightening tube so as to make the distance between the surface of said Si molten liquid and the bottom end of said straightening tube increase during the crystal growth or keep it at a constant value; and

means for controlling the rotational speed of said motors (78A to 78C) so that the level of said straightening tube is equal to said reference level.

11. An apparatus according to claim 10', wherein starting from the leading end of a cylindrical portion of said Si single crystal (36), said reference level increases proportionally in accordance with the increase of said variable Z.

**Patentansprüche**

1. Verfahren zur Herstellung eines Si-Einkristalls (36) mittels Anordnen eines Richtrohres (40) konzentrisch mit und oberhalb eines Quarztiegels (22), Hinunterfließen lassen von Inertgas durch das Richtrohr, Eintauchen eines Keimkristalls in eine Si-Schmelze (28) in dem Quarztiegel und anschließend Hochziehen des Keimkristalls, wobei das Verfahren weiterhin umfaßt ein Einstellen der Sauerstoffkonzentration in dem Si-Einkristall durch Regeln des Abstandes (H) zwischen der Oberfläche der Si-Schmelze und dem unteren Ende des Richtrohres entsprechend einer Variablen (Y) bei der es sich entweder um einen Hochzieh-Länge oder eine Hochzieh-Zeit von einem bestimmten Wachstumspunkt des Si-Einkristalls handelt, so daß der Abstand (H) während des Kristallwachstums sich erhöht oder auf einem gewünschten Wert ($H_0$ oder $H_1$) konstant gehalten wird.

2. Verfahren nach Anspruch 1, wobei der Abstand (H) zwischen der Oberfläche in der Si-Schmelze (28) und dem unteren Ende des Richtrohres (40) dadurch geregelt wird, daß das Richtrohr festgehalten und der Quarztiegel (22) angehoben werden, so daß der Abstand (H) während des Kristallwachstums sich erhöht oder auf einem gewünschten Wert ($H_0$ oder $H_1$) konstant gehalten wird.

3. Verfahren nach Anspruch 1, wobei der Abstand (H) zwischen der Oberfläche der Si-Schmelze (28) und dem unteren Ende des Richtrohres (40) dadurch geregelt wird, daß das Niveau des Quarztiegels (22) festgehalten und das Richtrohr angehoben werden.

4. Verfahren nach Anspruch 1, wobei der Abstand (H) zwischen der Oberfläche der Si-Schmelze (28) und dem unteren Ende des Richtrohres (40) geregelt wird, indem sowohl das Richtrohr als auch der Quarztiegel (22) angehoben werden, so daß der Abstand (H) während des Kristallwachstums sich erhöht oder auf einem gewünschten Wert ($H_0$ oder $H_1$) konstant gehalten wird.

5. Verfahren nach Anspruch 4, wobei der Quarztiegel (22) angehoben wird, um ein Niveau der Oberfläche der Si-Schmelze (28) aufrechtzuerhalten, so daß der Abstand (H) während des Kristallwachstums sich erhöht oder auf einem gewünschten Wert ($H_0$ oder $H_1$) konstant gehalten wird.

6. Verfahren nach Anspruch 1, wobei das Niveau des unteren Endes des Richtrohres (40) konstant ist, bis das obere Ende eines zylindrischen Abschnittes des Si-Einkristalls (36) detektiert wird, wobei der Abstand (H) zwischen der Oberfläche der Si-Schmelze 28 und dem unteren Ende des Richtrohres entsprechend der Erhöhung der Variablen (Y) während einer Hochzieh-Länge oder einer Hochzieh-Zeit von dem führenden Ende erhöht wird, und wobei das Niveau des Richtrohres konstant ist, bis die Gesamtheit des Si-Einkristalls (36) produziert worden ist, nachdem die Länge hochgezogen worden ist oder die Zeit vergangen ist.

7. Vorrichtung zum Einstellen der Sauerstoffkonzentration in einem Si-Einkristall umfassend einen Quarztiegel (22), der darin Si-Schmelze (28) enthält, und ein Richtrohr (40), das konzentrisch mit dem Quarztiegel (22) und oberhalb davon angeordnet ist und durch welches Inertgas nach unten fließt, und zur Herstellung eines Si-Einkristalls (36) durch Eintauchen eines Keimkristalls in die Si-Schmelze und anschließendes Hochziehen des Keimkristalls, mit:

einer Einrichtung zum Messen einer Variablen (Z), die entweder eine Hochzieh-Länge oder

7

eine Hochzieh-Zeit von einem bestimmten Wachstumspunkt des Si-Einkristalls ist;

einem Motor (42) zum Anheben des Quarztiegels;

einer Einrichtung (53) zum Setzen eines Durchmessers ($d_0$) eines Zylinderabschnittes des Si-Einkristalls, eines Innendurchmessers (D) des Tiegels (22), einer Dichte ($p_S$) des Si-Einkristalls, einer Dichte ($p_M$) der Si-Schmelze, einer bestimmten Länge ($Y_0$) des Si-Einkristalls und einer Konstanten (alpha);

einer Einrichtung zum Berechnen eines Referenzwertes (Vc) der Anhebegeschwindigkeit des Quarztiegels wie folgt:

falls $d < d_0$, dann Vc = $(p_S/p_m)$ $(d/D)^2$ Vs, wobei Vs die Hochziehgeschwindigkeit des Si-Einkristalls ist,

falls $d > d_0$, dann falls $Z < (1 - alpha) Y_0$, dann Vc = $((p_S/p_m)(dD)^2$ - alpha} Vs/(1 - alpha), ansonsten Vc = $(p_S/p_M)(d/D)^2$ Vs,

einer Einrichtung zum Regeln der Rotationsgeschwindigkeit des Motors, so daß die Anhebegeschwindigkeit des Quarztiegels gleich dem Referenzwert Vc ist.

8. Vorrichtung zum Einstellen der Sauerstoffkonzentration in einem Si-Einkristall, umfassend einen Quarztiegel (22), der Si-Schmelze (28) darin enthält und ein Richtrohr (40), das konzentrisch mit dem Quarztiegel (22) und oberhalb davon angeordnet ist und durch welches Inertgas nach unten fließt, und zum Produzieren eines Si-Einkristalls (36) durch Eintauchen eines Keimkristalls in die Si-Schmelze und anschließendes Hochziehen des Keimkristalls, mit:

einer Einrichtung zum Messen einer Variablen (Z), bei der es sich entweder um eine Hochzieh-Länge oder eine Hochzieh-Zeit von einem bestimmten Wachstumspunkt des Si-Einkristalls handelt;

Motoren (78A bis 78C) zum Anheben des Richtrohres;

Einrichtungen (80A bis 80C) zum Messen des Niveaus des Richtrohres; einer Einrichtung (86) zum Setzen eines Referenzniveaus des Richtrohres, um so den Abstand zwischen der Oberfläche der Si-Schmelze und dem unteren Ende des Richtrohres während des Kristallwachstums zu erhöhen oder diesen auf einem konstanten Wert zu halten; und

einer Einrichtung (88) zur Regelung der Rotationsgeschwindigkeit der Motoren, so daß das Niveau des Richtrohres gleich dem Referenzniveau ist.

9. Vorrichtung nach Anspruch 8, wobei ausgehend von dem führenden Ende eines zylindrischen Abschnitts des Si-Einkristalls (36) das Referenz niveau proportional entsprechend dem Anstieg der Variablen (Z) sich erhöht.

10. Vorrichtung zum Einstellen des Sauerstoffgehalts in einem Si-Einkristall umfassend einen Quarztiegel (22), der Si-Schmelze (28) darin enthält und ein Richtrohr (40), das konzentrisch mit dem Quarztiegel (22) und oberhalb davon angeordnet ist und durch das Inertgas nach unten fließt, und zum Produzieren eines Si-Einkristalls (36) durch Eintauchen eines Keimkristalls in die Si- Schmelze und anschließendes Hochziehen des Einkristalls, mit:

einem Motor (42) zum Anheben des Ouarztiegels;

einer Einrichtung zur Berechnung eines Referenzwertes der Anhebegeschwindigkeit des Quarztiegels, um so das Niveau der Oberfläche der Si-Schmelze konstant zu halten:

einer Einrichtung (54) zum Regeln der Rotationsgeschwindigkeit des Motors, so daß die Anhebegeschwindigkeit des Quarztiegels gleich dem Referenzwert ist;

Einrichtungen (48) und (50) zum Messen einer Variablen (Z), bei der es sich entweder um eine Hochzieh-Länge oder eine Hochzieh-Zeit von einem bestimmten Wachstumspunkt des Si-Einkristalls handelt;

Motoren (78A bis 78C) zum Anheben des Richtrohres;

Einrichtungen (80A bis 80C) zum Messen des Niveaus des Richtrohres; einer Einrichtung (86) zum Setzen eines Referenzniveaus des Richtrohres, um so den Abstand zwischen der Oberfläche der Si-Schmelze und dem unteren Ende des Richtrohres während des Kristallwachstums zu erhöhen oder diesen auf einem konstanten Wert zu halten; und

einer Einrichtung zum Regeln der Rotationsgeschwindigkeit der Motoren (78A bis 78C), so daß das Niveau des Richtrohres gleich ist dem Referenzniveaus.

11. Vorrichtung nach Anspruch 10, wobei ausgehend vom führenden Ende eines zylindrischen Abschnittes des Si-Einkristalls (36) das Referenzniveau proportional entsprechend dem Anstieg der Variablen (Z) erhöht wird.

**Revendications**

1. Procédé de production d'un monocristal de Si (36), qui consiste à disposer un tube redresseur (40) en position concentrique par rapport à un creuset en quartz (22) et au-dessus de ce dernier, à laisser circuler un gaz inerte vers le bas dans le tube redresseur, à tremper un germe cristallin dans le liquide de Si en fusion (28) dans ledit creuset en quartz, puis à tirer ledit germe cristallin vers le haut, le procédé comprenant en outre l'ajustement de la concentration de l'oxygène dans ledit monocristal de Si grâce au contrôle de la distance (H) entre la surface dudit liquide de Si en fusion et l'extrémité inférieure dudit tube redresseur en fonction d'une variable (Y) qui est soit la longueur d'étirage, soit le temps d'étirage, pour un certain point de croissance dudit monocristal de Si, de manière à ce que la distance H, durant la croissance du cristal, augmente ou soit maintenue constante à une valeur voulue $H_0$ ou $H_1$.

2. Procédé selon la revendication 1, dans lequel on contrôle la distance (H) entre la surface dudit liquide de Si en fusion (28) et l'extrémité inférieure dudit tube redresseur (40) en fixant ledit tube redresseur et en élevant ledit creuset en quartz (22) pour que la distance H, durant la croissance du cristal, augmente ou soit maintenue constante à une valeur voulue $H_0$ ou $H_1$.

3. Procédé selon la revendication 1, dans lequel on contrôle la distance (H) entre la surface dudit liquide de Si en fusion (28) et l'extrémité inférieure dudit tube redresseur (40) en fixant le niveau dudit creuset en quartz (22) et en élevant ledit tube redresseur.

4. Procédé selon la revendication 1, dans lequel l'on contrôle la distance (H) entre la surface dudit liquide de Si en fusion (28) et l'extrémité inférieure dudit tube redresseur (40) en élevant à la fois ledit tube redresseur et ledit creuset en quartz (22) pour que la distance H, durant la croissance du cristal, augmente ou soit maintenue constante à une valeur voulue $H_0$ ou $H_1$.

5. Procédé selon la revendication 4, dans lequel on élève ledit creuset en quartz (22) de manière à maintenir un niveau de la surface dudit liquide de Si en fusion (28) tel que la distance H, durant la croissance du cristal, augmente ou soit maintenue constante à une valeur voulue $H_0$ ou $H_1$.

6. Procédé selon la revendication 1, dans lequel le niveau de l'extrémité inférieure dudit tube redresseur (40) est constant jusqu'à ce que l'extrémité supérieure de la partie cylindrique dudit monocristal de Si (36) soit détectée, on augmente la distance (H) entre la surface dudit liquide de Si en fusion (28) et l'extrémité inférieure dudit tube redresseur en fonction de l'augmentation de ladite variable (Y) au cours d'une longueur d'étirage ou d'un temps d'étirage de ladite extrémité avant, et le niveau dudit tube redresseur est constant jusqu'à ce que l'ensemble dudit monocristal de Si (36) soit produit après que ladite longueur ait été étirée ou ledit laps de temps soit écoulé.

7. Appareil pour ajuster la concentration d'oxygène dans un monocristal de Si, comprenant un creuset en quartz (22) qui contient le liquide de Si en fusion (28) et un tube redresseur (40) qui est placé de façon concentrique avec ledit creuset en quartz (22) et au-dessus de ce dernier et à travers lequel circule, vers le bas, un gaz inerte, et pour produire un monocristal de Si (36) par trempage d'un germe cristallin dans ledit liquide de Si en fusion, puis étirage dudit germe cristallin vers le haut, comprenant :

   un moyen de mesure d'une variable Z, qui est soit la longueur d'étirage, soit le temps d'étirage, pour un certain point de croissance dudit monocristal de Si ;

   un moteur (42) pour élever ledit creuset en quartz ;

   un moyen (53) de réglage du diamètre $d_o$ d'une partie cylindrique dudit monocristal de Si, le diamètre intérieur D dudit creuset (22), la masse volumique $\rho_S$ dudit monocristal de Si, la masse volumique $\rho_M$ dudit liquide de Si en fusion, une certaine longueur $Y_0$ dudit monocristal de Si et une constante $\alpha$ ;

   un moyen de calcul d'une valeur de référence $V_c$ de la vitesse d'élévation dudit creuset en quartz de la manière suivante,

   si $d < d_o$, $V_c = (\rho_S/\rho_M) \bullet (d/D)^2 V_S$, où $V_S$ est la vitesse d'étirage dudit monocristal de Si,

   si $d \geq d_o$, et si $Z < (1-\alpha)Y_0$,
$V_c = \{(\rho_S/\rho_M) \bullet (d/D)^2 - \alpha\}V_S/(1-\alpha)$, ou alors
$V_c = (\rho_S/P_M) \bullet (d/D)^2 V_s$ ;

   un moyen de contrôle de la vitesse de rotation dudit moteur pour que la vitesse d'élévation dudit creuset en quartz soit égale à ladite valeur $V_c$ de référence.

8. Appareil pour ajuster la concentration d'oxygène dans un monocristal de Si, comprenant un creuset en quartz (22) qui contient le liquide de Si en fusion (28) et un tube redresseur (40) qui est placé de façon concentrique avec ledit creuset en quartz (22) et au-dessus de ce dernier et à travers lequel circule, vers le bas, un gaz inerte, et pour produire un monocristal de Si (36) par trempage d'un germe cristallin dans ledit liquide de Si en fusion, puis étirage dudit germe cristallin vers le haut, comprenant

:

un moyen de mesure d'une variable Z, qui est soit la longueur d'étirage, soit le temps d'étirage, pour un certain point de croissance dudit monocristal de Si ;

des moteurs (78A à 78C) pour élever ledit tube redresseur ;

des moyens (80A à 80C) de mesure du niveau dudit tube redresseur ;

des moyens (86) de réglage d'un niveau de référence dudit tube redresseur, pour augmenter la distance entre la surface dudit liquide de Si en fusion et l'extrémité inférieure dudit tube redresseur au cours de la croissance du cristal ou pour la maintenir à une valeur constante ; et

un moyen (88) de contrôle de la vitesse de rotation desdits moteurs pour que le niveau dudit tube redresseur soit égal audit niveau de référence.

9. Appareil selon la revendication 8, dans lequel, à partir de l'extrémité avant de la partie cylindrique dudit monocristal de Si (36), ledit niveau de référence augmente proportionnellement à l'augmentation de ladite variable Z.

10. Appareil pour ajuster la concentration d'oxygène dans un monocristal de Si, comprenant un creuset en quartz (22) qui contient le liquide de Si en fusion (28) et un tube redresseur (40) qui est placé de façon concentrique avec ledit creuset en quartz (22) et au-dessus de ce dernier et à travers lequel circule, vers le bas, un gaz inerte, et pour produire un monocristal de Si (36) par trempage d'un germe cristallin dans ledit liquide de Si en fusion, puis étirage dudit germe cristallin vers le haut, comprenant :

un moteur (42) pour élever ledit creuset en quartz ;

un moyen de calcul d'une valeur de référence de la vitesse d'élévation dudit creuset en quartz de manière à maintenir constant le niveau de la surface dudit liquide de Si en fusion ;

un moyen (54) de contrôle de la vitesse de rotation du moteur de manière à ce que ladite vitesse d'élévation dudit creuset en quartz soit égale à ladite valeur de référence ;

des moyens (48 et 50) de mesure d'une variable Z, qui est soit la longueur d'étirage, soit le temps d'étirage, pour un certain point de croissance dudit monocristal de Si ;

des moteurs (78A à 78C) pour élever ledit tube redresseur ;

des moyens (80A à 80C) de mesure du niveau dudit tube redresseur ;

des moyens (86) de réglage d'un niveau de référence dudit tube redresseur, pour augmenter la distance entre la surface dudit liquide de Si en fusion et l'extrémité inférieure dudit tube redresseur au cours de la croissance du cristal ou pour la maintenir à une valeur constante ; et

un moyen de contrôle de la vitesse de rotation desdits moteurs (78A à 78C) pour que le niveau dudit tube redresseur soit égal audit niveau de référence.

11. Appareil selon la revendication 10, dans lequel, à partir de l'extrémité avant de la partie cylindrique dudit monocristal de Si (36), ledit niveau de référence augmente proportionnellement à l'augmentation de ladite variable Z.

F I G.1

FIG. 2

EP 0 425 837 B1

F I G. 3

F I G.4

F I G.5

FIG.6

FIG.7

FIG. 8

EP 0 425 837 B1